# EUROPEAN PATENT APPLICATION

(11) **EP 1 906 255 A1**
(43) Date of publication of application: **02.04.2008**
(21) Application number: 06020705.7
(22) Date of filing: 02.10.2006
(51) Int. Cl.: G03F 7/20

(54) **Immersion lithographic processing using an acid component source for reducing watermarks**

(30) Priority: 27.09.2006 GB 0619043
(71) Applicant: Interuniversitair Microelektronica Centrum, 3001 Leuven (BE); Intel Corporation, Santa Clara, CA 95052-8119 (US)
(72) Inventor: Kocsis, Michael, Santa Clara, CA 95054 (US); Gronheid, Roel, 3370 Boutersem (BE)
(74) Representative: Bird, Ariane

(57) **Abstract**

A method for immersion lithographic processing is described wherein a reduction of watermark defects (254) is obtained without putting stringent requirements on the immersion scanning speed. The method comprises obtaining (302) a substrate (6) with resist layer (4) and providing (304) contact between an acid component source (252) and that resist layer (4). The acid component source (252), which may be an acid component or a photo-acid generator, is adapted to provide an acid concentration within a range having a minimum concentration larger than 0 mol% and a maximum concentration such that resists lines obtained through said lithographic processing are substantially not dissolved. During the containing (304), illumination (306) of the resist layer (4) according to a predetermined pattern is performed. The invention also relates to an immersion liquid (4) comprising such an acid component source (252) and to a top coating comprising such an acid component source (252).

## Description

### Technical field of the invention

The present invention relates to the field of lithographic processing of devices, e.g. in semiconductor processing. More particularly, the present invention relates to systems and methods for immersion lithographic processing.

### Background of the invention

In the production of today's integrated circuits, optical lithography is one of the key techniques. The ongoing miniaturisation of integrated circuits or other devices results in a number of problems, which may be encountered during optical lithography. When, in an optical lithographic system, light generated by a light source is incident on a mask, the light will be diffracted. The smaller the dimensions of the structures on this mask, the more the light will spread. Hence, the smaller the dimensions of the structures on the mask, the less of this spread-out light will be collected by an objective lens so as to be focused onto a resist layer. As a result, the image of the mask structure formed onto the resist layer will be of a low quality. A well-known solution to cope with the light spreading and consequently to obtain sufficient quality of the mask image is the use of systems having a high numerical aperture (NA). Typically immersion liquids are used to deal with the corresponding incidence of light having a high angle of incidence onto the wafer.

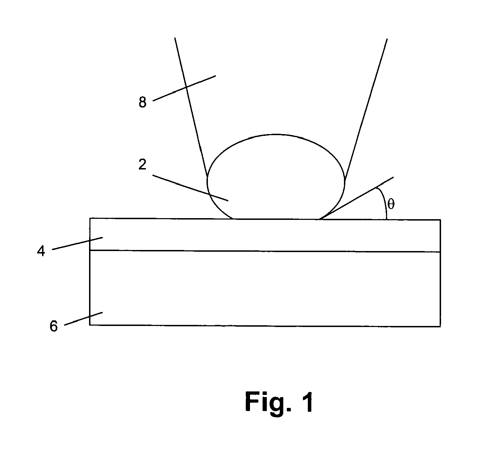

Implementing immersion lithography has given rise to a number of particular problems, for example associated with the use of an immersion liquid in contact with the resist layer used in the lithographic process. One of the problems arising is the presence of watermark defects on the lithographic processed devices. Watermark defects occur when water droplets, e.g. released by the nozzle of an immersion hood, remain on the device to be processed, dry on the surface and leave a residue of dissolved components. Water drops may be left on the surface e.g. when the receding contact angle between the immersion liquid and the substrate surface is too small. The receding contact angle θ between the immersion liquid 2 and the resist or resist stack 4 on the substrate 6 is shown in Fig. 1. Furthermore, the immersion hood 8 also is illustrated. Typically, such defects can affect the development process, resulting in bridging or T-topping defects occurring in circular patterns. Watermark defects typically have a diameter in the range of 1 µm to 5 µm, thus resulting in a high kill ratio. The occurrence of a watermark defect therefore may results in a non-useful die on the substrate.

One known technique for reducing or preventing watermark defects is the increase of the receding contact angle between the immersion hood and the resist. The receding contact angle can be altered e.g. by adjusting the hydrophobic character of the surface of the resist or top layer thereon, by adjusting the scanning speed, the type of showerhead, etc. Illustrations thereof are described e.g. Streefkerk B. et al., Proceedings of SPIE 6154 (2006) and in Kocsis M. et al., Proceedings of SPIE 6154 (2006). An alternative method for reducing or preventing watermarks is described by Kusumoto S. et al. in Polym. Adv. Technol. 17 (2006) 122. The document describes the use of topcoats that are not porous to water. The effect of rinsing on watermark defects also has been studied. The above solutions introduce limitations for the resist or resist stacks used, e.g. with respect to their wettability, and/or to the lithographic system used, e.g. with respect to the shape and scanning speed of the immersion hood.

### Summary of the invention

It is an object of the present invention to provide good systems and methods for immersion lithographic processing of devices. It is an advantage of embodiments according to the present invention that the number of watermark defects can be reduced, while still obtaining an efficient lithographic process. It is also an advantage of embodiments according to the present invention that the number of watermark defects can be reduced without significantly influencing the resist stack used or the speed of writing in the immersion lithographic process.

The above objective is accomplished by a method and device according to the present invention.

The present invention relates to a method for immersion lithographic processing of a device, the method comprising obtaining a substrate with a resist layer, providing contact between an acid component source and said resist layer, the acid component source providing an acid concentration within a range having a minimum concentration larger than 0 mol% and a maximum concentration such that resist lines obtained through said lithographic processing are substantially not dissolved, and, during said contact, illuminating said resist layer according to a predetermined pattern. Larger than 0 mol% thereby refers to the intentional doping. With larger than 0 mol%, no reference is made to the unintentional doping level in the immersion liquid.

It is an advantage of embodiments according to the present invention that the number of watermark defects occurring on the device is reduced and/or that the intensity of the watermark defects occurring on the device is reduced. It is an advantage of embodiments according to the present invention that the number of watermark defects can be reduced or even avoided without substantially reducing the efficiency of the lithographic system, e.g. by reducing the speed of the immersion hood used in the system. The maximum concentration may be dependent on the acid used and/or on the resist used.

The immersion lithographic processing may comprise using an immersion liquid, wherein providing an acid component source in contact with said resist layer comprises any of adding an acid component source to the immersion liquid used or providing a top layer on said resist layer, the top layer comprising the acid component source. It is an advantage of such embodiments that the illumination settings do not need to be substantially altered when applying embodiments according to the present invention.

Providing an acid component source may comprise providing a photo-acid generator. It is an advantage of such embodiments that the acid is only made available during illumination, thus limiting the effects of acids on non patterned parts of the substrate.

Providing an acid component source may comprise providing an acid component. It is an advantage of such embodiments that the acid component also may prevent watermark defects in not illuminated parts of the device.

Providing an acid component source may comprise providing between 10⁻⁵ mol percentage and 10⁻² mol percentage of acid component, e.g. between 10⁻⁴ mol percentage and 10⁻² mol percentage of acid component.

Providing an acid component source may comprise providing a fluor based acid.

The fluor based acid may comprise any of a fluor based sulfonic acid or a fluor based acetic acid.

Providing an acid component may comprise providing trifluoromethanesulfonic acid or an acid halide, anhydride or ester derivative thereof.

The acid component may be acid component in molecular form, e.g. the acid component in a top coating may be acid component in molecular form.

The acid component may be acid component that is mobile in a top layer covering the resist layer.

Resist lines obtained through said lithographic processing being substantially not dissolved may comprise dissolving of resist material resulting in less than 50% of the height of the resist lines being removed.

The present invention also relates to a lithographic processing system, the system comprising an acid component source providing means for providing contact between an acid component source and a resist layer of a device to be lithographic processed, the acid component source providing an acid concentration within a range having a minimum concentration larger than 0 mol% and a maximum concentration such that resist lines obtained through said lithographic processing are substantially not dissolved. Larger than 0 mol% thereby refers to the intentional doping. With larger than 0 mol%, no reference is made to the unintentional doping level in the immersion liquid.

The acid concentration may be between 10⁻⁵ mol percentage and 10⁻² mol percentage of acid component, e.g. between 10⁻⁴ mol percentage and 10⁻² mol percentage of acid component.

The acid component source providing means or provider is a means or provider for providing an immersion liquid comprising an acid component source between an immersion hood and the device to be lithographic processed.

The present invention also relates to an immersion liquid for use in immersion lithographic processing of a device and for bringing in contact with a resist layer on the device, the immersion liquid comprising an acid component source, the acid component source providing an acid concentration within a range having a minimum concentration larger than 0 mol% and a maximum concentration such that resist lines obtained through said lithographic processing are substantially not dissolved. Larger than 0 mol% thereby refers to the intentional doping. With larger than 0 mol%, no reference is made to the unintentional doping level in the immersion liquid. The acid concentration may be between 10⁻⁵ mol percentage and 10⁻² mol percentage of acid component, e.g. between 10⁻⁴ mol percentage and 10⁻² mol percentage of acid component.

The present invention furthermore relates to the use of an immersion liquid as described above in immersion lithographic processing of a device for reducing watermark defects.

The present invention also relates to a top coating for use in lithographic processing of a device and for being provided on top of a resist layer of the device, the top coating comprising an acid component source, the acid component source providing an acid concentration within a range having a minimum concentration larger than 0 mol% and a maximum concentration such that resist lines obtained through said lithographic processing are substantially not dissolved. The acid concentration may be between 10⁻⁵ mol percentage and 10-² mol percentage of acid component, e.g. between 10⁻⁴ mol percentage and 10⁻² mol percentage of acid component.

The present invention also relates to the use of a top coating as described above in immersion lithographic processing of a device for reducing watermark defects. Particular and preferred aspects of the invention are set out in the accompanying independent and dependent claims. Features from the dependent claims may be combined with features of the independent claims and with features of other dependent claims as appropriate and not merely as explicitly set out in the claims. The acid concentration may be between 10⁻⁵ mol percentage and 10⁻² mol percentage of acid component, e.g. between 10⁻⁴ mol percentage and 10⁻² mol percentage of acid component.

Although there has been constant improvement, change and evolution of devices in this field, the present concepts are believed to represent substantial new and novel improvements, including departures from prior practices, resulting in the provision of more efficient, stable and reliable devices of this nature.

The teachings of the present invention permit the design of improved semiconductor devices, e.g. integrated circuits, and improved manufacturing processes for semiconductor devices having a higher manufacturing yield.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 illustrates the receding contact angle between an immersion liquid droplet and a substrate surface, as typically present in an immersion lithographic processing system known from prior art.
Fig. 2 illustrates an exemplary immersion lithographic processing system as can be used in a method according to embodiments of the present invention.
Fig. 3 illustrates part of an immersion lithographic set-up according to an embodiment of the present invention.
Fig. 4 illustrates a typical watermark defect, known from prior art.
Fig. 5 illustrates a method of immersion lithographic processing according to embodiments of the present invention.
Fig. 6a is an illustration of a lithographically process test pattern processed using an immersion liquid with a too high acid concentration illustrating possibilities and limitations of embodiments of the present invention.
Fig. 6b is an illustration of a lithographically process test pattern processed using an immersion liquid with low acid concentration, illustrating possibilities and limitations of methods according to embodiments of the present invention.

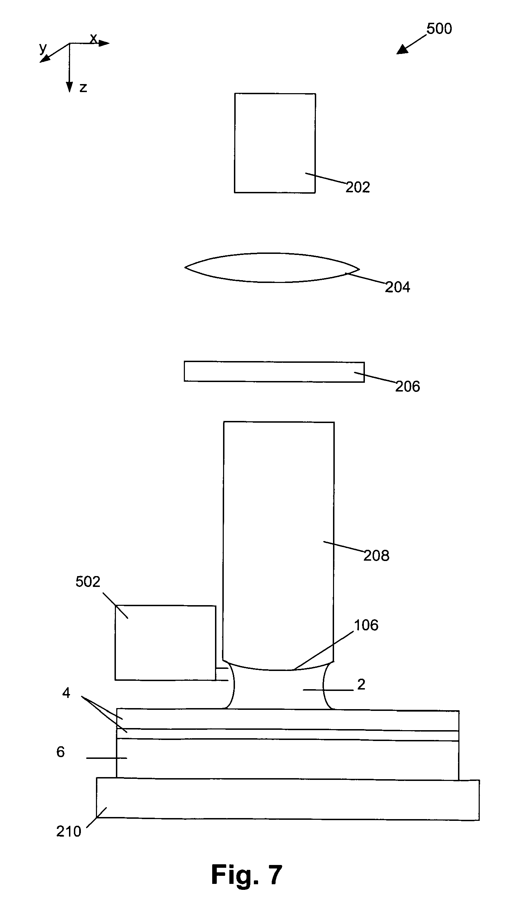

Fig. 7 illustrates an exemplary immersion lithographic processing system adapted for use in a method according to embodiments of the present invention.
Fig. 8a, 8b and 8c illustrate watermark defects occurring on lithographically processed devices, that have been lithographically processed with an immersion liquid comprising a triflic acid concentration of 1.12x10⁻² mol%, 1.12x10⁻³ mol% and 0 mol% illustrating a principle of a method according to embodiments of the present invention.
Fig. 9 illustrates watermark defects obtained for different concentrations of nonaflic acid or TPSN PAG in a top coating on two different types of resist, illustrating a principle of a method according to embodiments of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments. Various features may be grouped in a single embodiment, figure or description. However, is not to be interpreted as reflecting an intention that the claimed invention requires more features than are expressly recited in each claim. The claims following the detailed description are hereby expressly incorporated into this detailed description, with each claim standing on its own as a separate embodiment of this invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following terms are provided solely to aid in the understanding of the invention. In embodiments of the present application, the term "substrate" may include not only the basic carrier material but also materials to be processed and typical materials applied for performing a lithographic processing step, such as for example - but not limited to - a bottom anti-reflective coating. The term "substrate" furthermore also may include other materials, such as e.g. other materials used in semiconductor processing. The basic carrier material may be for example doped or undoped silicon, silicon-on-insulator substrate (SOI), gallium arsenide (GaAs), gallium arsenide phosphide (GaAsP), indium phosphide (InP), germanium (Ge), or silicon germanium (SiGe), glass or quartz substrates. The term "contact" may refer both to direct contact, i.e. one object being adjacent to a second object without material being in between both objects, and to indirect contact, whereby one object is coupled to another object by means of other solid or liquid material, for example intermediate layers being present between the two objects or a liquid drop being present between the two objects. The term "resist stack" may refer to the combination of a resist layer and a bottom coating, i.e. a coating between the resist layer and the substrate, which optionally may be a bottom anti-reflective coating (BARC). Optionally, also a top coating may be present, e.g. being a protective coating or being a top anti-reflective coating (TARC). In the present application, top coating and top layer are used for referring to the same item.

Where in the present application reference is made to "light" or "radiation", electromagnetic radiation typically used in immersion lithographic systems is referred to. In present application, often electromagnetic radiation having a wavelength of 193nm is used, but the invention is not limited thereto and other wavelengths in the ultraviolet and/or deep ultraviolet range or even other types of electromagnetic radiation may be used.

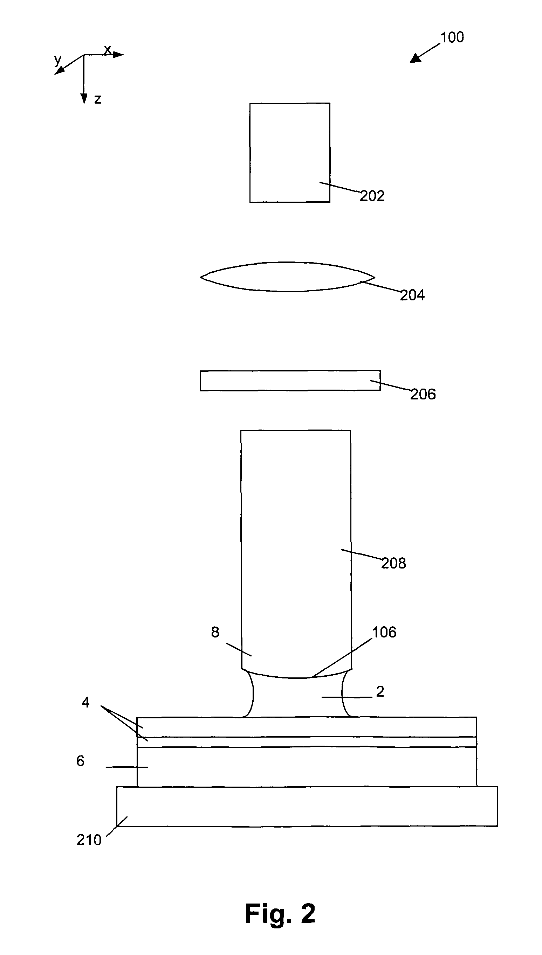

The embodiments of the present invention may be related to an immersion lithographic processing system. The method is applicable to lithographic processing which can be performed on any type of immersion lithographic set-up, such as but not limited to the set-up shown in Fig. 2, shown by way of illustration only. An optical lithographic system with a transmission set-up is shown, although the invention is not limited thereto and is e.g. also applicable to a system with a reflection set-up. It may be e.g. an immersion lithographic stepper system or an immersion lithographic scanner system. The optical immersion lithographic system 100 may comprise a source of electromagnetic radiation, e.g. an irradiation source 202. The radiation from the irradiation source 202 is, for example, transmitted through an optical system 204 comprising a lens and is incident on a mask 206. The mask 206 contains information about the image to be generated in a resist layer or resist stack 4 and is basically defined thereby. Optionally, the mask 206 may be part of a set of masks used for creating a device or circuit using lithography. Different types of masks exist; such as e.g. an alternated phase shift mask, an attenuated phase shift mask, a binary mask, etc. The light, carrying the mask information, is then passed through an imaging module 208, which e.g. may have a final lens surface 106, and thus is guided to a resist layer or resist stack 4 on a substrate 6. The optics of the imaging module 208 inherently defines the numerical aperture (N.A.) of the imaging module 208. The device 102 is optionally mounted on a substrate stage 210. Optionally, an immersion showerhead 8, also referred to as immersion hood 8, provides an immersion liquid 2 between the resist layer or resist stack 4 and the output of the imaging module 208, e.g. the final lens surface 106, in order to allow increase of the numerical aperture of the system 100. Other optional and/or additional components are not illustrated in Fig. 2. The system shown is only shown by way of illustration. For example, alternative systems that could be used are systems operating with micro-mirrors, e.g. systems used as optical mask writers.

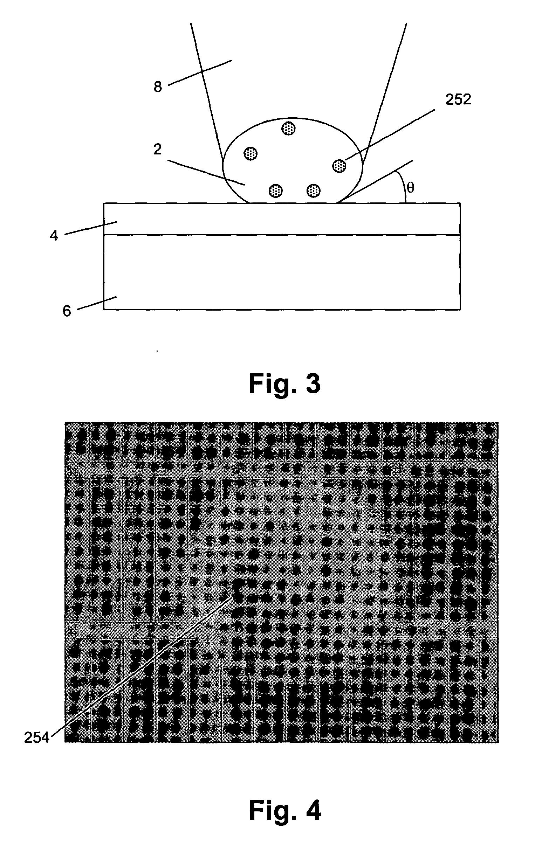

In a first aspect, the present invention relates to a method for lithographic processing of a device. The method comprises obtaining a substrate 6 with a resist layer 4 or resist stack. The substrate 6 may be any type of substrate used for producing e.g. a semiconductor device, as described above. Preferably the resist layer 4 or resist stack comprising a resist layer comprises resist suitable for immersion lithography, such as for example, but not limited to, Sumitomo PAR-IM850 resist. If a resist stack is present, besides a resist layer also a bottom anti-reflective coating and/or a top anti-reflective coating or a top protective coating may be present. The method also comprises providing an acid component source 252 in contact with the resist layer 4 and illuminating the resist layer 4 according to a predetermined pattern. The latter is shown by way of example in Fig. 3. The acid component source 252 thereby is able to provide an acid concentration within a range having a minimum concentration larger than 0% mol and a maximum concentration such that resist lines obtained through the lithographic processing are substantially not dissolved, i.e. substantially undissolved. With substantially not dissolved, there is meant that the resist height in the pattern is at least half of the original resist height. Providing an acid component source 252 in contact with the resist layer 4 may be performed for example by providing an acid component in the immersion liquid 2 used, or for example by providing an acid component in a top layer on the resist layer 4. By providing an acid component in contact with the resist layer 4, the number of watermark defects occurring on the device can be reduced or watermark defects can even be avoided. A typical watermark defect 254 is illustrated in Fig. 4. Reduction of watermark defects may be a reduction of the number of watermark defects and/or a reduction of the size and/or intensity of the watermark defects.

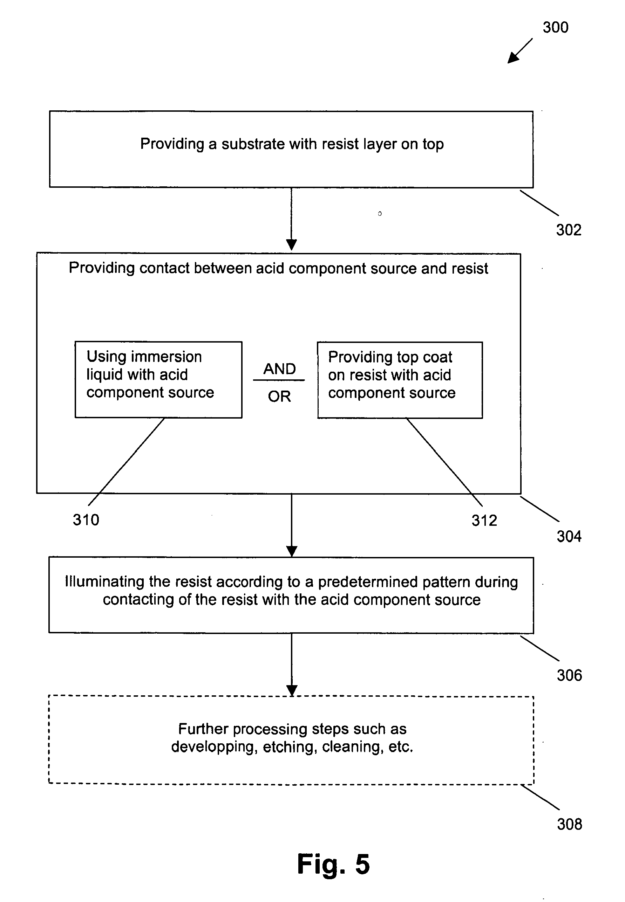

An exemplary method 300 for lithographic processing of a device according to the first aspect is shown in Fig. 5, illustrating different standard steps and optional steps.

A first step 302 comprises obtaining a substrate 6 with a resist layer 4 or a resist stack on top. The latter may comprise depositing on a substrate 6 a resist layer 4 or it may comprise obtaining a substrate 6 whereon a resist layer 4 is already deposited. The substrate 6 may be any type of substrate as described above and the resist layer 4 may be any suitable resist layer. The resist material used may be positive or negative resist and/or chemically amplified resist. The resist material preferably is especially suitable for immersion lithographic processing. A typical example of such a resist material is e.g. PAR-IM850 as obtainable from Sumitomo Corporation.

In a second step 304, an acid component source 252 is provided in contact with the resist layer 4. The acid component source 252 in contact with the resist layer 4 results in a different interaction between immersion liquid 2 drops remaining on the resist layer 4 or resist stack and the resist layer 4 or resist stack itself. The latter results in a reduction of and optionally in a complete removal of watermark defects. A reduction of watermark defects 254 may comprise a reduction of the density of watermark defects 254 and/or a reduction of the intensity and/or size of the watermark defect 254, i.e. the degree in which the watermark defect 254 is pronounced. Providing an acid component source 252 may for example be performed by using 310 an immersion liquid with acid component source, i.e. by adding an acid component source 252 to the immersion liquid 2. The acid component source thereby may be either an acid component and/or a photo-acid generator. Alternatively or in addition thereto, providing an acid component source 252 may also be obtained by providing an acid component source 252 in a top coat on the resist layer, also being an acid component and/or a photo-acid generator. In other words, a top coat with acid component source may be provided 312 on the resist 4.

In a third step 306, the method 300 comprises irradiating the resist layer 4 according to a predetermined pattern, while the acid component source 252 is in contact with the resist layer 4. The irradiating thereby preferably is performed by scanning an immersion hood 8 of the system 200 over the device, whereby immersion liquid 2 provides contact between the optical components in the immersion hood 8 with the device to be processed. Irradiating is performed during or alternating with the scanning, and it is performed according to a predetermined pattern. In embodiments wherein the acid component source 252 is initially added as a photo-acid generator, the irradiating step allows generation of acid component by converting photo-acid generator in acid component. Preferably, the parameters of the irradiation, such as e.g. dose or exposure date, and the amount of photo-acid generator provided in the acid component source 252 are tuned to each other such that a preferred amount of acid component is generated during the irradiating. The parameters of the irradiation in the irradiating step thereby may be adapted, although preferably the amount of photo-acid generator (PAG) is adapted for obtaining the appropriate acid component concentration. Further features of the irradiating step may be as known in the art.

The method 300 furthermore may comprise other optional lithographic processing steps 308 such as a developing step, one or more baking steps, one or more etching steps, etc. The obtained pattern may be used in a number of applications, such as e.g. depositing material in a predetermined pattern, removing material in a predetermined pattern, doping material in a predetermined pattern, treating material according to a predetermined pattern, etc. Other steps that may be performed are for example cleaning steps. These optional steps and other optional steps are known from prior art.

Each of the above steps may be performed in an automatic and/or automated way. Such steps may be implemented by a computerised means for carrying out the function, e.g. by a processor of such a computer system. Thus a processor with the necessary instructions for carrying out such a method or a step thereof forms a means for carrying out the method or a step thereof in an automated way.

It is an advantage of embodiments according to the present invention that the provided acid component will counter-balance the acid depletion from the resist during lithographic processing.

The invention will now further be described by a detailed description of several particular embodiments of the invention. It is clear that other embodiments of the invention can be configured according to the knowledge of persons skilled in the art without departing from the true spirit or technical teaching of the invention, the invention being limited only by the terms of the appended claims.

In a first particular embodiment, a method as described above in the first aspect is disclosed, wherein the step of providing contact between the acid component source 252 and the resist layer is obtained by depositing a top coating or top layer on the resist layer, comprising an acid component source 252. Preferably the acid component source in the top coats are acid component sources providing acid components which are not in polymeric form. The acid components preferably are acid components in molecular form. In other words, the acid components preferably are in such a form that they are mobile in the resist layer, i.e. that they are not immobilised. In this way the acid components can e.g. counterbalance acid depletion. It is an advantage of such embodiments of the present invention that the topcoat is used as protection layer against watermarks. Providing an acid component source 252 in the top coating may be incorporating an acid component source 252 providing or generating acid component with a concentration sufficiently small that the resist lines produced in the lithographic process are substantially not dissolved, but larger than 0%. A concentration sufficiently small that the resist lines produced in the lithographic process are not dissolved may depend on the type of resist used. The concentration being sufficiently small may be such that less than 50%, preferably less than 20% more preferably less than 10%, even more preferably less than 1% of the height of the resist lines is dissolved, i.e. the less the material of the resist lines is dissolved, the better. The lower limit for the concentration of acid component is that it should be larger than 0%. The preferred limits for the concentration of the acid component used may depend on the type of acid component used. In particular examples, the concentration ranges used may be between 10⁻³ mol percentage and 10⁻² mol percentage, the invention not being limited thereto. The acid component source 252 provided in the top coating may be acid component provided in the top coating or may be a photo-acid generator provided in the top coating. When a photo-acid generator is used, the concentration provided in the top coating may be adapted to the irradiation parameters and the conversion efficiency for converting photo-acid generator in acid component, as to obtain an appropriate concentration of acid component in contact with the resist layer, as described above. Examples of photo-acid generators (PAG) that may be used are Ciba® IRGACURE® PAG 1XX, Ciba® IRGACURE® PAG 203, 2-[2,2,3,3,4,4,4-heptafluoro-1-(nonafluorobutylsulfonyloxyimino)-butyl]-fluorene or 2-[2,2,3,3,4,4,5,5-octafluoro-1-(nonafluorobutylsulfonyloxyimino)-pentyl]-fluorene, triphenylsulfonium nonafluoro-n-butanesulfonate (TPST), triphenylsulfonium trifluoromethanesulfonate (TPSN), triphenylsulfonium perfluoro-n-octanesulfonate (TPSO). The top coating may be any suitable type of top coating, such as e.g. a dielectric layer stack, e.g. SiO₂/TiO₂. Such top coatings may be top coatings that are used on resist for immersion applications, being organic polymeric materials. Such top coatings may be fluorinated polymers because of their high hydrophobicity and good transparancy. The top coating may further be a top anti-reflective coating or may also provide another functionality. An advantage of providing the acid component source in the top coat is that, in cases e.g. a top-anti-reflective coating is preferred, the latter brings the acid component in direct contact with the resist layer. Another advantage of methods according to the present embodiment is that no direct contact between the acid component source and the optics of the immersion system is present. In a preferred embodiment, the top coating thereby is selected such as not to have an intermixing layer with the resist material. In a particular example, the resist used may be a PAR817 resist.

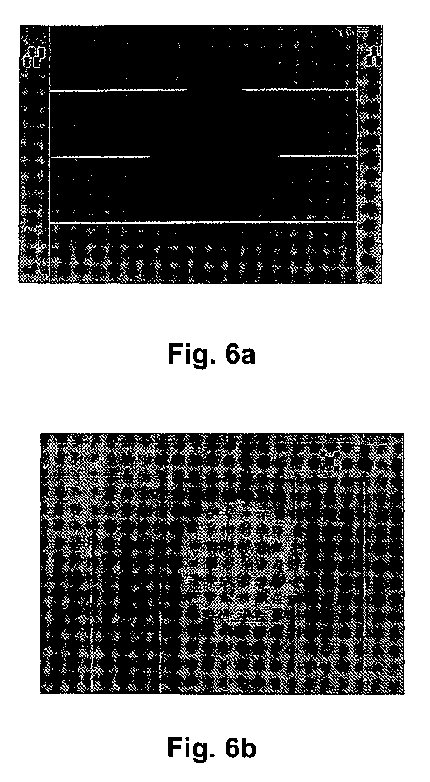

In a second particular embodiment, a method as described above in the second aspect is disclosed, wherein the step of providing contact between an acid component source 252 and the resist layer 4 comprises providing an acid component source 252 in the immersion liquid 2 used in the immersion lithographic processing and contacting the resist layer 4 directly or indirectly, e.g. by contacting the resist stack, with the immersion liquid. Indirect contact between the acid component source 252 and the resist layer 4 may be obtained by contacting the acid component source 252 with a top coat on the resist layer 4. In other words, the second particular embodiment may be combined with the first particular embodiment. Providing an acid component source 252 in the immersion liquid 2 may be providing an acid component source 252 in the immersion liquid providing acid component with a concentration sufficiently small that the resist lines produced in the lithographic process are substantially not dissolved, but larger than 0%. A concentration sufficiently small that the resist lines produced in the lithographic process are not dissolved may depend on the type of resist used. The concentration being sufficiently small may be such that less than 50%, preferably less than 20% more preferably less than 10%, even more preferably less than 1% of the resist lines is dissolved, i.e. the less the material of the resist lines is dissolved, the better. The lower limit for the concentration of acid component is that it should be larger than 0%. The preferred limits for the concentration of the acid component used may depend on the type of acid component used. The preferred concentration range may be between 10⁻⁵ mol percentage and 10⁻² mol percentage, e.g. between 10⁻⁴ mol percentage and 10⁻² mol percentage, e.g. between 10⁻⁴ mol percentage and 5.10⁻² mol percentage. In particular examples, the concentration ranges used may be between 10⁻³ mol percentage and 10⁻² mol percentage, the invention not being limited thereto. An example of a resulting watermark defect whereby more than the preferred acid concentration is provided is shown in Fig. 6a, whereas an example of a resulting defect for immersion lithographic processing whereby less than the preferred acid concentration is provided but more than 0 mol% is provided is shown in Fig. 6b. The acid component source 252 may be obtained by directly providing acid component in the immersion liquid or by providing photo-acid generator in the immersion liquid and converting it when irradiating the resist, through the immersion liquid. The concentration of photo-acid generator may e.g. be adapted to the parameters of the irradiation and to the efficiency for converting photo-acid generator in acid component. Possible immersion liquids that can be used are a mixture of standard immersion liquid, such as e.g. water, and acid component. Such an acid component may e.g. be a fluor based acid, such as for example a fluor based sulfonic acid or a fluor based acetic acid. An example thereof may be trifluoromethanesulfonic acid or an acid halide, anhydride or ester derivate thereof. Optionally, all sulphonic acids may be used. Furthermore also photochemical precursors to such acids may be used. Furthermore most very strong inorganic acids are of interest sulphuric acid, phosphoric acid, HBF₄, HSbF₆, ... Another particular example of an acid that may be used is a non afluorobutanesulphonic acid, also known as nonaflic acid. Providing the acid component source in the immersion liquid has the advantage that the composition of a top coating does not need to be changed.

In a second aspect, the present invention relates to an immersion liquid for use in immersion lithographic processing of a device. According to the second aspect, the immersion liquid 2 comprises an acid component source 252. The acid component source 252 may be acid component directly provided in the immersion liquid 2, or it may be for example introduced as a photo-acid generator (PAG), generating acid component when exposed to the lithographic irradiation beam. Providing such an acid component source 252 results in reduction and optionally even avoiding watermark defects in the device. The reduction of the watermark defects may be a reduction of the intensity of watermark defects and/or a reduction of the number of watermark defects occurring on the device. The reduction thereby may be obtained without reducing the standard speed of movement of the immersion hood in immersion lithographic processing. The immersion liquid may comprise standard immersion liquid, such as e.g. water or second generation high index liquids such as e.g. cyclic olefins. If water is used, other additives also may be added, e.g. for increasing the conductivity of the immersion liquid. According to an embodiment of the present invention, the immersion liquid also comprises an acid component. The acid component thereby preferably is provided in a concentration sufficiently small that the resist lines produced in the lithographic process are substantially not dissolved, but larger than 0%. A concentration sufficiently small that the resist lines produced in the lithographic process are not dissolved may depend on the type of resist used and may be such that less than 50%, preferably less than 20% more preferably less than 10%, even more preferably less than 1% of the resist lines is dissolved, i.e. the less the material of the resist lines is dissolved, the better. The lower limit for the concentration of acid component is that it should be larger than 0%. In one example, the acid concentration may be between 1×10⁻³ mol% and 1×10⁻² mol%.

A third aspect according to the present invention relates to the use of an immersion liquid comprising an acid component source for reducing watermark defects on a device obtained by immersion lithographic processing. The immersion liquid thereby may be brought in contact with the resist layer, e.g. in direct or indirect contact as described above. The immersion liquid may be an immersion liquid as described in the second aspect of the present invention.

A fourth aspect according to the present invention relates to a top coating for use in immersion lithographic processing of a device for covering a resist layer. The top coating comprises an acid component source 252. The acid component source 252 may be acid component directly provided in the top coating 2, or it may be for example introduced as a Photo Acid Generator (PAG), generating acid component when exposed to the lithographic irradiation beam. Providing such an acid component source 252 results in reduction and optionally even avoiding watermark defects in the device. The reduction of the watermark defects may be a reduction of the intensity of watermark defects and/or a reduction of the number of watermark defects occurring on the device. The concentration of acid component provided or generated may be as described in any of the aspects, embodiments or examples of the present invention. The top coating may comprise any suitable top coating materials. It may e.g. be a dielectric layer stack, e.g. SiO₂/TiO₂ or another top coating e.g. as described above. The top coating may further be a top anti-reflective coating or may also provide another functionality.

A fifth aspect according to the present invention relates to the use of a top coating comprising an acid component source in lithographic processing of a device for reducing watermark defects on a device obtained by immersion lithographic processing. The top coating thereby may be at least partially covering the resist layer. The top coating may be a top coating as described in the fourth aspect of the present invention.

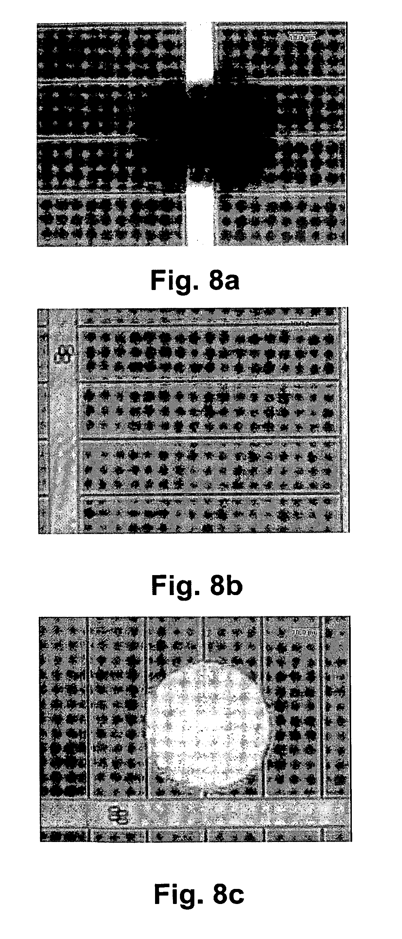

A sixth aspect according to the present invention relates to a lithographic processing system as shown in Fig. 8. Such a system is described above with respect to Fig. 2 whereby the lithographic processing system furthermore is adapted to provide an immersion liquid comprising an acid component source during the immersion lithographic processing. The system 500 therefore may comprise an acid component source providing means 502. The acid component source providing means 502 may e.g. be a container adapted for comprising acid component source and having an outlet for providing the acid component source in the immersion liquid, prior to use of the immersion liquid at the immersion hood. Alternatively or in addition thereto the system also may comprise a container adapted for comprising mixed standard immersion liquid and an acid component source. It is an advantage of embodiments according to the present invention that an efficient lithographic processing system may be obtained with reduced watermark defects on the processed devices, e.g. compared to prior art systems wherein the speed of the immersion hood of the immersion lithographic system is reduced to avoid water drops being left on the surface of the resist or top layer.

By way of illustration, the invention not being limited thereto, the different aspects of the present invention will be further illustrated by way of an example whereby immersion lithographic processing is performed using immersion liquids with different acid component concentrations. In the present example, the resist used is PAR-IM850 resist and the immersion liquid used is a mixture of standard immersion liquid, in the present example being water, and trifluoromethanesulfonic acid (CF₃SO₃H). The different acid component concentrations used are 0 mol%, 1.12×10⁻³ mol%, 1.5×10⁻³ mol%, 2.24×10⁻³ mol%, 4.48×10⁻³ mol% and 0.0112 mol%. No watermarks could be identified for concentrations 1.5×10⁻³ mol%, 2.24×10⁻³ mol% and 4.48×10⁻³ mol%, illustrating advantages of embodiments according to the present invention. In Fig. 8a, illustrating a watermark defect occurring when using immersion liquid with a 0.0112 mol% trifluoromethanesulfonic acid concentration, it can be seen that the watermark results in destroying the resist lines, resulting in errors in the device. The resist under the droplet is completely rinsed away in the developer. In Fig. 8b, a watermark defect is shown occurring when using immersion liquid with a 0 mol% trifluoromethanesulfonic acid concentration, i.e. without trifluoromethanesulfonic acid or more generally without acid components being present. It can be seen that t-topping occurs for such a watermark defect. Fig. 8c illustrates improvement of the watermark defect, i.e. reduction of the intensity of the watermark defect, for a concentration slightly higher than 0 %mol trifluoromethanesulfonic acid concentration, it is for 1.12x10⁻³ mol% trifluoromethanesulfonic acid. As mentioned above, for three exemplary concentrations in the range between 1.12x10⁻³ mol% and 0.0112 mol% trifluoromethanesulfonic acid, no watermark defects were present on the device. The latter illustrates the advantages of embodiments according to the present invention.

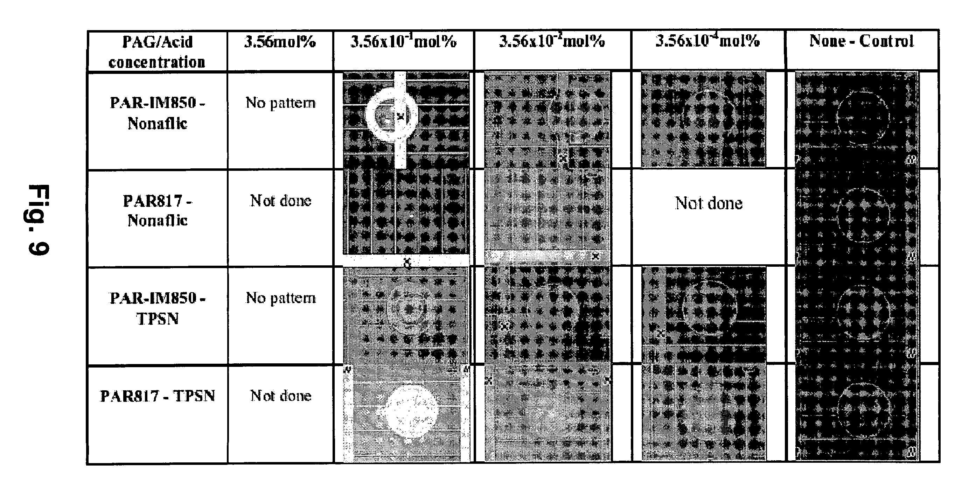

In another example, an acid component source is added to the top coating. Both mixing an acid component directly with the top coating and providing a photo-acid generator has been performed. In the latter case, the exposure will generate acid component by converting the photo-acid generator. In the present example, a TCX 041 top coat as available for example from JSR Corporation was used and varying amounts of triflic acid (CF₃SO₃H), nonaflic acid (C₄F₉SO₃H) or TPSN PAG were used. In a first experiment, tests were performed on PAR-IM850 resist. Only little impact could be seen of the different top coats on the watermark defect. It thereby is to be noticed that typically the TCX041 top coating forms an intermixing layer with PAR-IM850 resist layer and that the number of watermark defects with this top coat is relatively high. In a further experiment, the test was repeated for a PAR817 resist layer as available for example from Sumitomo Corp.. In Fig. 9, some of the obtained results are shown, whereby watermark defects are shown for nonaflic acid mixed in a TCX041 top coating on PAR-IM850 resist and on PAR817 resist and for TPSN PAG mixed in a TCX041 top coating on PAR-IM850 resist and PAR817 resist. It can be seen that the effect of adding acid component showed the most significant improvement with respect to the watermark defects problem for the nonaflic acid top coatings.

Other arrangements for accomplishing the objectives of the methods and systems embodying the invention will be obvious for those skilled in the art.

It is to be understood that although preferred embodiments, specific constructions and configurations, as well as materials, have been discussed herein for devices according to the present invention, various changes or modifications in form and detail may be made without departing from the scope and spirit of this invention.

## Claims

1. A method (300) for immersion lithographic processing of a device, the method (300) comprising
- obtaining (302) a substrate (6) with a resist layer (4),
- providing (304) contact between an acid component source (252) and said resist layer (4), the acid component source (252) providing an acid concentration within a range having a minimum concentration larger than 0 mol% and a maximum concentration such that resist lines obtained through said lithographic processing are substantially not dissolved,
- and, during said contact, illuminating (306) said resist layer (4) according to a predetermined pattern.

2. A method (300) according to claim 1, the immersion lithographic processing comprising using an immersion liquid (2),
wherein providing (304) an acid component source (252) in contact with said resist layer (4) comprises any of adding an acid component source (252) to the immersion liquid (2) used or providing a top layer on said resist layer (4), the top layer comprising the acid component source (252).

3. A method (300) according to any of claims 1 to 2, wherein providing an acid component source (252) comprises providing a photo-acid generator.

4. A method (300) according to any of claims 1 to 3, wherein providing an acid component source (252) comprises providing an acid component.

5. A method (300) according to any of claims 1 to 4, wherein providing an acid component source (252) comprises providing between 10⁻⁵ mol percentage and 10⁻² mol percentage of acid component.

6. A method (300) according to any of claims 1 to 5, wherein providing an acid component source (252) comprises providing a fluor based acid.

7. A method (300) according to claim 6, wherein said fluor based acid comprises any of a fluor based sulfonic acid or a fluor based acetic acid.

8. A method (300) according to claim 7, wherein providing an acid component comprises providing trifluoromethanesulfonic acid or an acid halide, anhydride or ester derivative thereof.

9. A method (300) according to 5, wherein the acid component concentration is between 10⁻⁴ mol percentage and 5.10⁻² mol percentage.

10. A method (300) according to any of claims 1 to 9, wherein the acid component is acid component in molecular form.

11. A method (300) according to any of claims 1 to 10, wherein the acid component is acid component that is mobile in a top layer covering the resist layer.

12. A method (300) according to any of claims 1 to 11 wherein resist lines obtained through said lithographic processing being substantially not dissolved comprises dissolving of resist material resulting in less than 50% of the height of the resist lines being removed.

13. A lithographic processing system (500), the system (500) comprising an acid component source providing means (502) for providing contact between an acid component source (252) and a resist layer (4) of a device to be lithographic processed, the acid component source (252) providing an acid concentration within a range having a minimum concentration larger than 0 mol% and a maximum concentration such that resist lines obtained through said lithographic processing are substantially not dissolved.

14. A lithographic processing system (500) according to claim 13, wherein the acid component source providing means (502) is a means (502) for providing an immersion liquid (2) comprising an acid component source (252) between an immersion hood (8) and the device to be lithographic processed.

15. An immersion liquid (2) for use in immersion lithographic processing of a device and for bringing in contact with a resist layer on the device, the immersion liquid (2) comprising an acid component source (252), the acid component source (252) providing an acid concentration within a range having a minimum concentration larger than 0 mol% and a maximum concentration such that resist lines obtained through said lithographic processing are substantially not dissolved.

16. Use of an immersion liquid (2) as described in claim 15 in immersion lithographic processing of a device for reducing watermark defects.

17. A top coating for use in lithographic processing of a device and for being provided on top of a resist layer of the device, the top coating comprising an acid component source (252), the acid component source (252) providing an acid concentration within a range having a minimum concentration larger than 0 mol% and a maximum concentration such that resist lines obtained through said lithographic processing are substantially not dissolved.

18. Use of a top coating (2) as described in claim 17 in immersion lithographic processing of a device for reducing watermark defects.
